# EUROPEAN PATENT APPLICATION

(11) **EP 2 410 648 A1**
(43) Date of publication of application: **25.01.2012**
(21) Application number: 10007526.6
(22) Date of filing: 20.07.2010
(51) Int. Cl.: H02M 3/158, H03K 17/10

(54) **DC/DC converter circuit and method for controlling a DC/DC converter circuit**

(71) Applicant: Vincotech Holdings S.a.r.l., 2636 Luxembourg (LU)
(72) Inventor: Frisch, Michael, 82008 Unterhaching (DE); Temesi, Ernö, 2094 Nagykovàcsi (HU)
(74) Representative: Grünecker, Kinkeldey, Stockmair & Schwanhäusser

(57) **Abstract**

The present invention relates to a DC/DC converter circuit to be used in the field of MPPT for solar inverters, for step-up DC/DC conversion for high output voltages, and for chargers in electrical vehicles. The circuit comprises a first DC terminal and a second DC terminal, a first DC voltage being defined there between. It further comprises a positive split DC terminal and a midpoint terminal, a positive split DC voltage being defined there between. A negative split DC terminal is provided, a negative split DC voltage being defined between said negative split DC terminal and said midpoint terminal. A first switch and a second switch are provided, and a converter inductance is storing electric energy therein. A first diode is connected between a first terminal of said first switch and said positive split DC terminal, and a second diode is coupled between an internal midpoint and said midpoint terminal.

## Description

The present invention generally relates to converter circuits and, in particular, to a DC/DC converter circuit which can be used, for instance, in the field of maximum power point tracking, MPPT, for solar inverters, for step-up DC/DC converters with output voltages of more than 500 V, and for chargers in electrical vehicles.

In particular for solar cells, boosting converters are needed for boosting the voltage generated by the solar cells to an output voltage of, for instance, 700 V to 1000 V. In order to further provide a safety margin, the components for switching these voltages usually have to be produced with a voltage rating of about 900 V up to 1200 V. These components, however, are expensive and/or have severe limitations in their performance.

Presently, several topologies are used for performing the DC/DC boost conversion in the field of solar modules. Examples for recently developed inverter topologies can be found in the following documents by Michael Frisch and Ernö Temesi, all available from http://www.vincotech.com/en/products/power/documents.php:
"Advantages of NPC Inverter Topologies with Power Modules", July 2009.
"Design Concept for a Transformerless Solar inverter", Dec. 2009.
"Symmetrical Boost Concept for Solar Applications up to 1000V", Jan. 2009.

When employing such a conventional boost circuit, it is firstly known to use 900 V rated CoolMOS™ transistors as the required power switches. The advantage of these components can be seen in the fact that their switching losses are comparatively low. However, the voltage may not exceed said 900 V rated value. A further disadvantage of CoolMOS™ switches can be seen in the fact that they have comparatively high static losses and, moreover, are rather expensive.

On the other hand, when higher voltages have to be generated, conventional boost circuits also use insulted gate bipolar transistors, IGBT, as switches. These transistors have the advantage that they exhibit rather low static losses, but, on the other hand, have the drawback of high switching losses.

Finally, it is further known to use silicon carbide junction field-effect transistors, SiC J-FET, or silicon carbide metal oxide field-effect transistors, SiC MOSFET, with a rated voltage of 1200 V. This arrangement offers the best performance, low switching losses and a high voltage rating, but has the severe drawback of being very expensive.

The object underlying the present invention is to provide a DC/DC converter circuit which firstly can be operated to convert from or into high voltages as they occur in connection with solar cells, and secondly is highly efficient and involves low component costs.

This object is solved by the subject matter of the independent claims. Advantageous embodiments of the present invention are the subject matter of the dependent claims.

The present innovation is based on the idea that a DC/DC converter circuit has two switches which are connected between a positive and a negative split voltage and are connected to each other at an internal midpoint node. This internal midpoint node according to the present invention is connected via a diode to the midpoint terminal between the positive and the negative split voltage. A converter inductance is provided for storing electric energy therein.

At the beginning of each switching cycle, both switches are switched on, so that current is flowing through both switches and the converter inductance. According to the present invention, one of the two switches is switched off earlier than the second one and the current flows through said diode to the midpoint terminal. After a predefined time period, for instance, 100 nanoseconds, the second switch is also turned off, so that now the current flows through a further diode to the output and the diode which is provided between the internal midpoint and the midpoint terminal clamps the voltage towards ground. Consequently, the two switches have a balanced share of the output voltage.

The circuit is most efficient with split DC potentials as this is, for instance, the case for neutral point clamped, NPC, inverter designs. Here, the symmetry of the split voltage can be managed by the output circuit. The advantage of the present invention can be seen in the fact that the switches have to be rated only for half the voltage which the converter circuit outputs or receives. Thus, components such as MOSFETs or punch-through insulated gate bipolar transistors, PT-IGBT, can be employed for highly efficient parallel switching, which are available in a larger variety with a voltage rating of 600 V, but not as 1200 V components.

Highly efficient topologies such as the ones described in the Article Frisch, M., Temesi, E.: "High Efficient Topologies for Next Generation Solar inverter", Bodo's Power Electronics in Motion and Conversion, August 2008, which up to now needed expensive components such as silicon carbide MOSFETS or J-FETS, may now be realised with standard silicon MOSFETS or IGBTs when applying the principles of the present invention. Furthermore, high voltage boosters with an output voltage of up to 2000 V may be realised with components that are only rated for up to 1200 V.

A further advantage of the inventive DC/DC converter topology can be seen in the fact that it may be used for positive and negative booster circuits, and also for positive and negative buck circuits for down converting applications.

According to an advantageous embodiment, the idea of assigning a balanced share of the total voltage to each of two serially connected switches can also be employed for driving a bipolar junction transistor, BJT, or an emitter switched bipolar transistor, ESBT, coupled between the positive and negative split voltage terminals.

For a better understanding of the present invention, same will be explained in the following based on the embodiments shown in the Figures. Corresponding parts are given corresponding reference numerals and terms. Furthermore, those features or combinations of features which show or describe different embodiments may form separate inventive solutions in themselves. The invention will now be described by way of example with reference to the drawings, wherein:
- **Fig. 1**: is a circuit diagram of a DC/DC converter circuit configured as a positive voltage boosting converter;
- **Fig. 2**: is a timing diagram of the control voltages for the switches in Fig. 1;
- **Fig. 3**: is a timing diagram of the voltages across the two switches and the input voltage;
- **Fig. 4**: is a timing diagram of the currents for the switches and through the diode of Fig. 1, respectively;
- **Fig. 5**: is a schematic diagram of a DC/DC converter circuit according to a first topology;
- **Fig. 6**: is a schematic circuit diagram of a DC/DC converter circuit according to a second topology;
- **Fig. 7**: is a schematic diagram of a buck converter circuit according to a first topology;
- **Fig. 8**: is a circuit diagram of buck converter circuit according to a second topology;
- **Fig. 9**: is a circuit diagram of a positive booster using a bipolar junction transistor, BJT;
- **Fig. 10**: is circuit diagram of a positive booster using an emitter switched bipolar transistor, ESBT;
- **Fig. 11**: is a circuit diagram of a negative booster using a bipolar junction transistor, BJT.

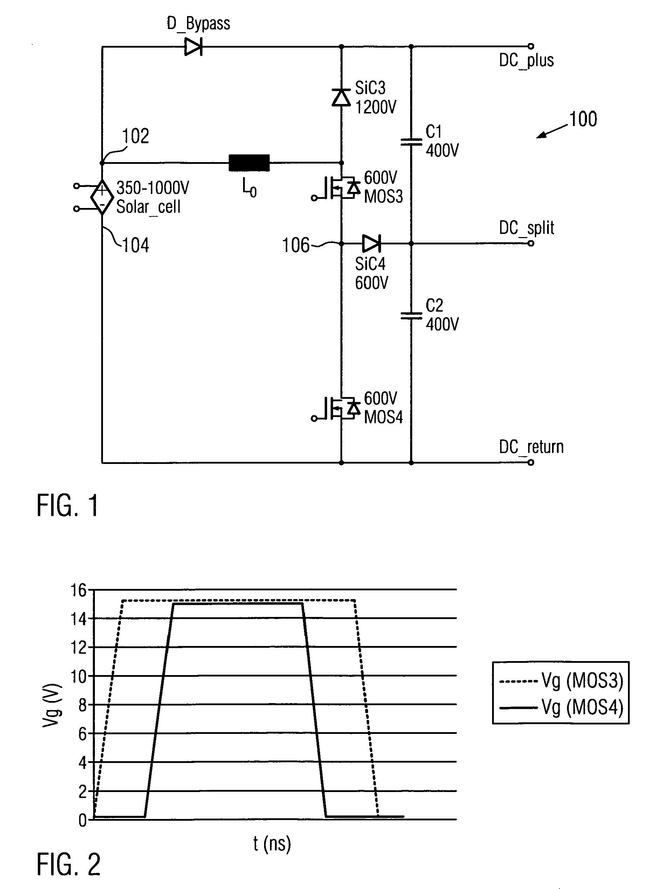

In Fig. 1, a DC/DC converter according to a first embodiment of the present invention is depicted. Generally, this DC/DC converter 100 is an element of a power conversion apparatus that converts DC power into AC power, for instance, in connection with solar systems. Conventionally, in such an inverter circuit the voltage from the power source, for instance, a solar battery, is boosted by using a DC/DC converter, and a pulse width modulation, PWM, controlled inverter is connected thereto at a subsequent stage, thus generating an output AC voltage which can, for instance, be fed into the power grid.

In particular, the DC power output from a solar battery drives an internal control power source of the power conditioner and thus enables an internal circuit to operate. The internal circuit comprises a booster circuit and an inverter unit. The booster circuit, often also called chopper circuit, boosts the voltage of the solar cell to a voltage that is required for linking to the system.

The inverter unit includes, for instance, four switches and carries out PWM switching to form an output current having a phase synchronous with the system or grid voltage. A strip-like wave form is output in this manner and the time ratio for output is changed to control the average voltage of the output. The output voltage is further averaged by a smoothing filter provided on the output side and the AC power is output to the system, for instance, a national grid.

Fig. 1 shows a DC/DC converter circuit 100 which is particularly suitable for neutral point clamped, NPC, topologies. An overview of such NPC topologies can be derived, for instance, from Rodriguez et al.: "Multi Level Inverters: "A Survey of Topologies, Controls, and Applications", IEEE Transactions on Industrial Electronics, Vol. 49, No. 4, August 2002.

The DC/DC converter circuit 100 has first and second DC terminals 102, 104 which are connected to the output of a solar cell. A boosting inductor L₀ is connected with the first DC terminal 102 and further connected to a first terminal of a first switch MOS3. The first terminal of the first switch MOS3 is connected via a first diode SiC3 to a positive split DC voltage output DC_plus. The first diode SiC3 is connected to the first switch MOS3 in a way that its anode is connected to the switch and its cathode is connected to the terminal DC_plus.

The second terminal of the first switch MOS3 is connected to an internal midpoint node 106 to which the first terminal of a second switch MOS4 is also connected. The second switch MOS4 is further connected to the negative split DC terminal DC_return.

A midpoint terminal DC-split which can be connected to neutral potential is provided between two capacitors C1 and C2 which are coupled between the positive and negative split DC terminals DC_plus and DC_return, respectively.

According to the present invention, this midpoint terminal DC_split is connected via a second diode to the internal midpoint node 106. In the circuit shown in Fig. 1, the second diode SiC4 is connected with its anode to the internal midpoint node 106 and with its cathode to the midpoint terminal DC split. Optionally, a bypass diode may be provided between the positive DC split terminal DC_plus and the DC input terminal 102. In the shown configuration, the first diode SiC3 is a silicon carbide diode which is rated for 1200 V. The second diode SiC4 is also a silicon carbide diode which is however rated only for 600 V. The two switches MOS3 and MOS4 are two MOSFETS each rated for 600 V.

At the beginning of each switching cycle, the two switches MOS3 and MOS4 are either switched on simultaneously or with a certain time delay, switching on the second switch MOS4 later than the first switch MOS3. When both switches are conductive, current flows through the boost inductor L₀ and the two switches MOS3 and MOS4. According to the present invention, the second switch MOS4 is switched off, while the first switch MOS3 is still conducting. Then, the current flows via the second diode SiC4 to the midpoint terminal which can be connected to neutral (ground). After a predetermined time delay of, for instance, 100 nanoseconds, the first switch MOS3 is also switched off and the current will then flow through the first diode SiC3 to the positive split DC terminal DC_plus.

According to the present invention, the diode between the internal midpoint node 106 and the midpoint terminal DC_split, SiC4, clamps the voltage to ground, so that the first and second switches MOS3, MOS4 have a balanced share of the output voltage.

Consequently, an output voltage of 800 V can be provided by using components which are rated only for half of this voltage.

Fig. 2 shows the control signals Vg for the first and second switches MOS3, MOS4 as a function of the time. In the embodiment shown in Fig. 2, the two switches are controlled to be switched on with a time delay. However, also a simultaneous switching would be feasible for turning on the switches. As shown in Fig. 2, the first switch MOS3 is turned on before the second switch MOS4 is turned on. This time delay may, for instance, amount to 100 nanoseconds, but can also have any other suitable value. After a predetermined time, the second switch MOS4 is switched off while the first switch MOS3 is still controlled to be conductive. MOS3 is switched off after a time delay of, for instance, 100 nanoseconds. These control signals Vg of course do not have to be symmetric as shown in Fig. 2, but can also have different values for the two time delays between switching on the two switches and switching same off.

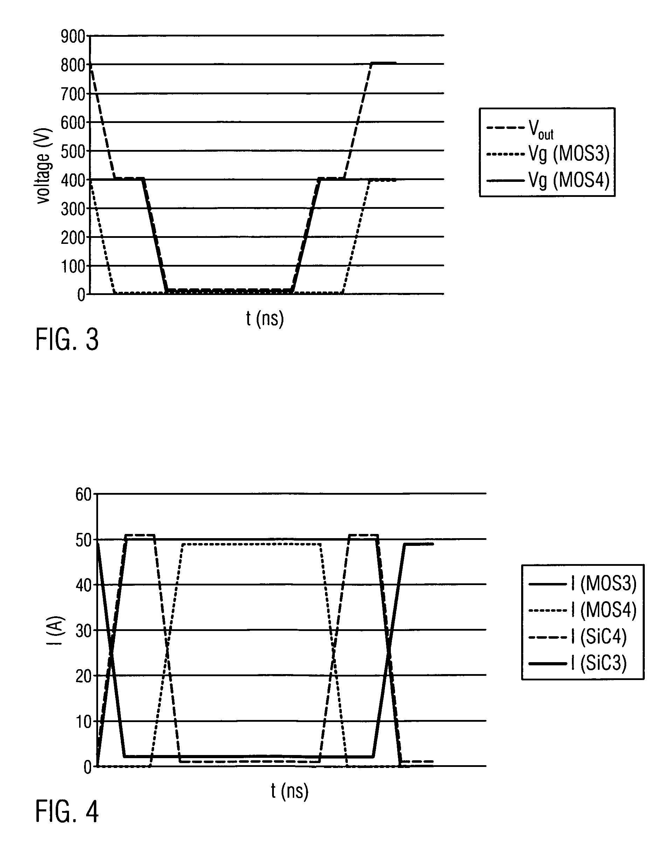

Fig. 3 shows the resulting voltages across the two switches and between the positive split DC terminal DC_plus and the midpoint terminal DC_split, referred to as V(MOS3), V(MOS4), and Vout, respectively.

As can be seen in Fig. 3, both switches MOS3 and MOS4 are only stressed by the voltage of 400 V whereas the output Vout voltage of the boost converter reaches 800 V. Thus, the switches MOS3 and MOS4 have only to be rated to allow, for instance, 600 V.

Fig. 4 shows the currents flowing through the two switches MOS3 and MOS4 and through the two diodes SiC3 and SiC4. As may be derived from this figure, the diodes carry the current only during short intervals during the time shifted switching process.

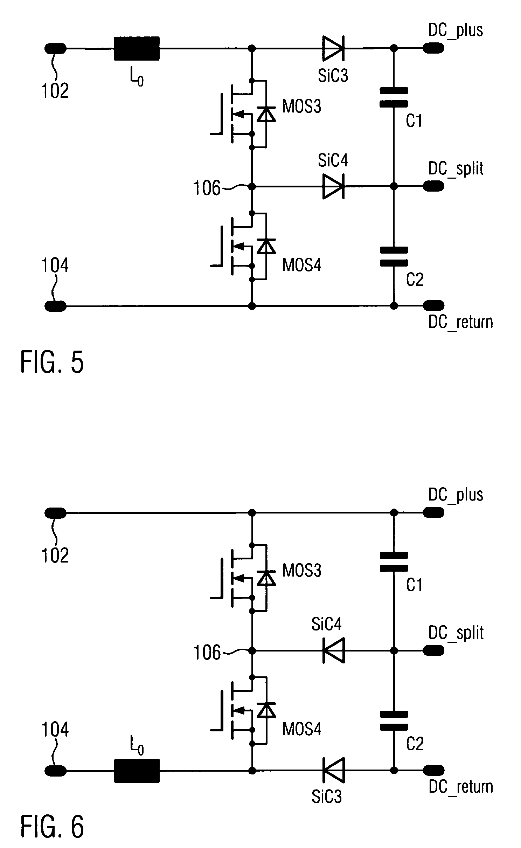

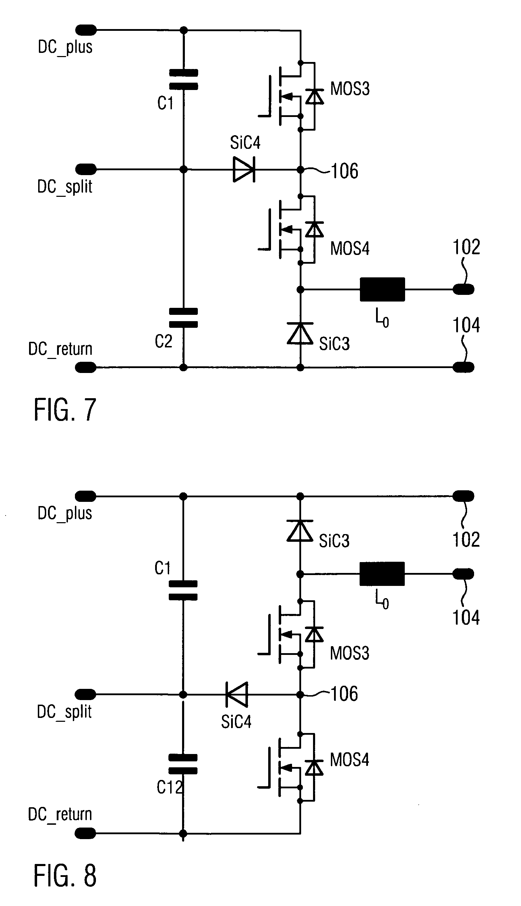

As will be explained with reference to Figs. 5 to 8, the basic principles of the circuit shown in Fig. 1 and basically represented also in Fig. 5, can be used not only for the positive boosting circuit of Figs. 1 and 5, but also for a negative boosting circuit (shown in Fig. 6) and down converting buck converters (shown in Fig. 7 and 8).

When directly comparing the positive boosting circuit of Fig. 5 to the negative boosting circuit of Fig. 6, the boost inductor L₀ is placed between the second terminal of the second switch and the second DC terminal 104. As the output voltage is a negative voltage, the second diode SiC4 has to be arranged with its cathode connected to the internal midpoint node 106. The first diode is arranged between the negative DC split terminal DC_return and the second terminal of the second switch MOS4. The control timing of the switches is performed analogously to the timing sequences explained above with respect to Figs. 2 to 4.

The inventive idea of a diode between the midpoint terminal DC split and an internal midpoint node 106 between the two switches MOS3 and MOS4 may also be applied for designing a buck converter, as well for a positive buck converter as for a negative buck converter. These two topologies are depicted in Figs. 7 and 8.

In comparison to Figs. 5 and 6, input and output terminals are interchanged. Also in these embodiments, by providing a diode SiC4 between the internal midpoint node 106 and the DC split neutral terminal, and by switching the two switches MOS3 and MOS4 in a delayed manner with respect to each other, it is feasible to convert high voltages down to lower output voltages by using switches that need to be voltage rated only for half the input voltage value.

The converter inductance L₀ here is located at the output DC terminals 102, 104 as this is generally characteristic of a buck converter.

The inventive circuit is able to provide boost or buck DC converters which are able to convert between high voltage differences and on the other hand, can be designed with standard cost effective semiconductor components.

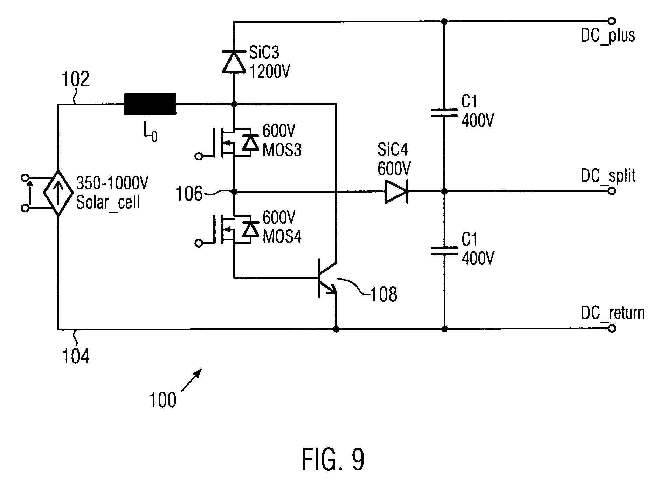

An advantageous application of the principle of assigning a balanced voltage share to two serially connected switches will be explained with reference to Figs. 9 to 11. Here, the circuit as described before is used for driving a bipolar junction transistor, BJT, or an emitter switched bipolar transistor, ESBT, 108 connected between the positive and negative split voltage terminals DC_plus and DC_return, respectively.

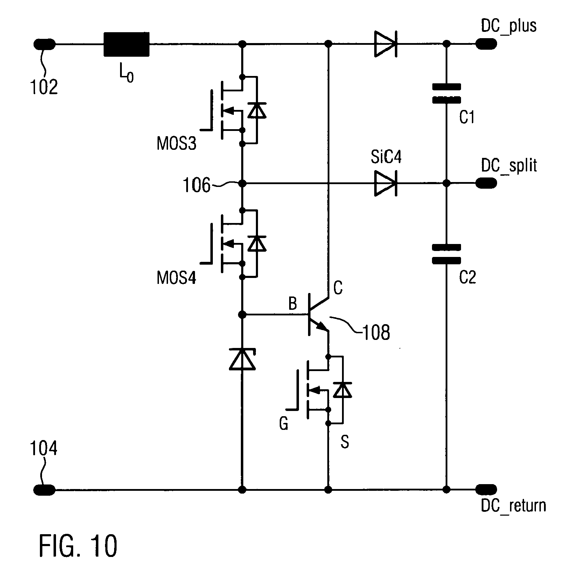

As this is generally known, the Emitter-Switching Bipolar Transistor, ESBT, is a combination of a NPN bipolar transistor, BJT, and a MOSFET. The BJT has an enhanced voltage blocking characteristic. The fast switching low voltage n-channel power MOSFET is realized inside the emitter of the BJT. An equivalent circuit is shown in Fig. 10. In order to drive the BJT and MOSFET independently, two separate terminals, gate and base, are required. Thus four terminals are necessary for the cascaded structure. The driving according to the present invention is performed by two MOSFETs connected in series, wherein their internal midpoint node 106 is coupled via a diode SiC4 to the midpoint terminal DC_split.

According to the present invention, the two MOSFETs MOS3 and MOS4 need to be voltage rated only for half the value that is needed for driving the BJT or ESBT 108.

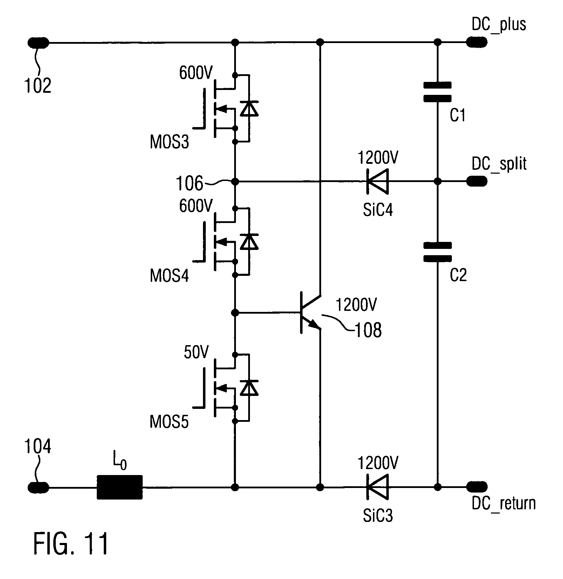

Figs. 9 and 10 show the arrangement of a positive booster using a BJT or ESBT 108, respectively, whereas Fig. 11 represents a negative booster topology. In this case, for switching off the BJT or ESBT 108 a third MOSFET MOS5 having a smaller block voltage is provided. The block voltage may for instance be 50 V.

The switching sequence of the circuit shown in Fig. 11 for switching on the BJT or ESBT 108 may for instance be as follows:
● turn off the switch off transistor MOS5;
● turn on the second switch MOS4, thus switching on the BJT or ESBT 108;
● turn on the first switch MOS3.

On the other hand, when turning off the BJT or ESBT 108, the following steps have to be performed:
● firstly, the switch off transistor MOS5 is turned on, thus the BJT or ESBT 108 starts turning off, and the three MOSFETS take over the current;
● in a second step, the first MOSFET MOS3 is turned off;
● finally, the second switch MOS4 is turned off.

The use of the ESBT generally offers the advantages that storage and switch off times are much shorter than those of traditional BJT, that the tail current characteristic of IGBT is not present, that there is no second breakthrough, which enhances the robustness, and that the safe operating area is much larger. With known driver circuits, high voltage MOSFETs are employed for driving the ESBT. According to the present invention, two serially connected MOSFETs having only half the rated voltage can be used by assigning a balanced share of the total voltage to each of them.

## Claims

1. DC/DC converter circuit comprising:
a first DC terminal (102) and a second DC terminal (104), wherein a first DC voltage is defined between said first and second DC terminals;
a positive split DC terminal (DC_plus) and a midpoint terminal (DC_split), wherein a positive split DC voltage is defined between said positive split DC terminal (DC_plus) and said midpoint terminal (DC_split);
a negative split DC terminal (DC_return), wherein a negative split DC voltage is defined between said negative split DC terminal (DC_return) and said midpoint terminal (DC_split);
a first switch (MOS3) and a second switch (MOS4) that are connected in series;
a converter inductance (L₀) for storing electric energy therein;
a first diode (SiC3) being connected between a first terminal of said first switch (MOS3) and said positive split DC terminal (DC_plus) or said negative split DC terminal (DC_return);
wherein an internal midpoint (106) between said first switch (MOS3) and said second switch (MOS4) is connected to said midpoint terminal (DC_split) via a second diode (SiC4).

2. DC/DC converter circuit according to claim 1, being configured as a positive voltage-boosting converter for a neutral point clamped, NPC, inverter circuit, wherein said first and second DC terminals (102, 104) are configured to be connected to a DC input voltage;
wherein said positive split DC terminal (DC_plus) is configured to output said positive split DC voltage with reference to said midpoint terminal (DC-split), and wherein said negative split DC terminal (DC_return) is configured to output said negative split DC voltage with reference to said midpoint terminal (DC_split);
wherein said converter inductance (leo) is connected between said first DC terminal said first terminal of said first switch (MOS3), wherein a second terminal of said first switch (MOS3) is connected to said internal midpoint (106);
wherein an anode of said first diode (SiC3) is connected to said first switch (MOS3) and a cathode of said first diode (SiC3) is connected to said positive split DC terminal (DC_plus);
wherein an anode of said second diode (SiC4) is connected to the second terminal of said first switch (MOS3) and a first terminal of said second switch (MOS4), and wherein a cathode of said second diode (SiC4) is connected with the midpoint terminal (DC_split).

3. DC/DC converter circuit according to claim 2, further comprising a bypass diode (D_Bypass) being coupled between the first DC terminal (102) and said positive split DC terminal (DC_plus), wherein an anode of the bypass diode is connected to the first DC terminal (102) and a cathode of the bypass diode (D_Bypass) is connected to the positive split DC terminal (DC_plus).

4. DC/DC converter circuit according to one of the claims 2 or 3, further comprising a bipolar junction transistor, BJT, or an emitter switched bipolar transistor, ESBT, which is connected with a collector terminal and an emitter terminal between said positive split DC terminal (DC_plus) and said negative split DC terminal (DC_return), wherein a base terminal of said BJT or ESBT is connected to said internal midpoint (106) via said second switch (MOS4).

5. DC/DC converter circuit according to claim 4, further comprising a Zener diode being arranged between said base terminal of said BJT or ESBT (108) and said second DC terminal (104).

6. DC/DC converter circuit according to claim 1, being configured as a negative voltage-boosting converter for a neutral point clamped, NPC, inverter circuit, wherein said first and second DC terminals (102, 104) are configured to be connected to a DC input voltage;
wherein said positive split DC terminal (DC_plus) is configured to output said positive split DC voltage with reference to said midpoint terminal (DC-split), and wherein said negative split DC terminal (DC_return) is configured to output said negative split DC voltage with reference to said midpoint terminal (DC_split);
wherein said converter inductance (L₀) is connected between said second DC terminal (104) and a second terminal of said second switch (MOS4), wherein a first terminal of the second switch (MOS4) and a second terminal of said first switch (MOS3) are connected to said internal midpoint (106);
wherein an anode of said first diode (SiC3) is connected to said negative split DC terminal (DC_return) and a cathode of said first diode (SiC3) is connected to said second switch (MOS4);
wherein a cathode of said second diode (SiC4) is connected to the second terminal of said first switch (MOS3) and a first terminal of said second switch (MOS4), and wherein an anode of said second diode (SiC4) is connected with the midpoint terminal (DC_split).

7. DC/DC converter circuit according to claim 6, further comprising a bipolar junction transistor, BJT, or an emitter switched bipolar transistor, ESBT, which is connected with a collector terminal and an emitter terminal between said positive split DC terminal (DC_plus) and said negative split DC terminal (DC_return), wherein a base terminal of said BJT or ESBT is connected to said internal midpoint (106) via said second switch (MOS4).

8. DC/DC converter according to claim 6, further comprising a switch off transistor (MOS5) being connected between said base terminal of said BJT or ESBT (108) and said second DC terminal (104).

9. DC/DC converter circuit according to claim 1, being configured as a positive buck converter, wherein said first and second DC terminals (102, 104) are configured to output a DC input voltage;
wherein said positive split DC terminal (DC_plus) is configured to be connected to a positive split DC input voltage with reference to said midpoint terminal (DC_split), and wherein said negative split DC terminal (DC_return) is configured to be connected to a negative split DC input voltage with reference to said midpoint terminal (DC_split);
wherein said converter inductance (L₀) is connected between said first DC terminal (102) and a second terminal of said second switch (MOS4), wherein a first terminal of the second switch (MOS4) and a second terminal of said first switch (MOS3) are connected to said internal midpoint (106);
wherein an anode of said first diode (SiC3) is connected to said negative split DC terminal (DC_return) and a cathode of said first diode (SiC3) is connected to said second switch (MOS4);
wherein a cathode of said second diode (SiC4) is connected to the second terminal of said first switch (MOS3) and a first terminal of said second switch (MOS4), and wherein an anode of said second diode (SiC4) is connected with the midpoint terminal (DC_split).

10. DC/DC converter circuit according to claim 1, being configured as a negative buck converter, wherein said first and second DC terminals (102, 104) are configured to output a DC input voltage;
wherein said positive split DC terminal (DC_plus) is configured to be connected to a positive split DC input voltage with reference to said midpoint terminal (DC_split), and wherein said negative split DC terminal (DC_return) is configured to be connected to a negative split DC input voltage with reference to said midpoint terminal (DC_split);
wherein said converter inductance (L₀) is connected between said second DC terminal (104) and a first terminal of said first switch (MOS3), wherein a first terminal of the second switch (MOS4) and a second terminal of said first switch (MOS3) are connected to said internal midpoint (106);
wherein a cathode of said first diode (SiC3) is connected to said positive split DC terminal (DC_plus) and an anode of said first diode (SiC3) is connected to said first switch (MOS3);
wherein an anode of said second diode (SiC4) is connected to the second terminal of said first switch (MOS3) and a first terminal of said second switch (MOS4), and wherein a cathode of said second diode (SiC4) is connected with the midpoint terminal (DC_split).

11. DC/DC converter according to one of the preceding claims, wherein at least one of the first and second diodes (SiC3, SiC4) comprises a silicon carbide diode.

12. DC/DC converter according to one of the preceding claims, wherein at least one of the first and second switches (MOS3, MOS4) comprises a metal oxide semiconductor field effect transistor, MOSFET.

13. Method for controlling a DC/DC converter circuit, said converter circuit comprising:
a first DC terminal (102) and a second DC terminal (104), wherein a first DC voltage is defined between said first and second DC terminals;
a positive split DC terminal (DC_plus) and a midpoint terminal (DC-split), wherein a positive split DC voltage is defined between said positive split DC terminal (DC_plus) and said midpoint terminal(DC split);
a negative split DC terminal (DC_return), wherein a negative split DC voltage is defined between said negative split DC terminal (DC_return) and said midpoint terminal (DC_split);
a first switch (MOS3) and a second switch (MOS4);
a converter inductance (L₀) for storing electric energy therein;
a first diode (SiC3) being connected between a first terminal of said first switch (MOS3) and said positive split DC terminal (DC_plus);
a second diode (SiC4) coupled between an internal midpoint (106) and said midpoint terminal (DC_split);
wherein said method comprises the following steps:
switching on said first and second switches (MOS3, MOS4), so that current flows through the converter inductance (L₀) and both switches;
switching off the second switch (MOS4) after a first predetermined time interval, so that current flows through the second diode (SiC4) to said midpoint terminal (DC_split);
switching off the first switch (MOS3) after a second predetermined time interval, so that current flows through said first diode (SiC3) said positive split DC terminal (DC_plus).

14. Method according to claim 13, wherein said second switch (MOS4) is switched on after the first switch (MOS3) is switched on.

15. Method according to claim 13 or 14, wherein said first switch is switched off 100 nanoseconds later than said second switch.

16. Method according to one of the claims 13 to 15, wherein said second switch (MOS4) is switched on 100 nanoseconds after the first switch (MOS3) is switched on.
